# EUROPEAN PATENT APPLICATION

(11) **EP 2 762 994 A1**
(43) Date of publication of application: **06.08.2014**
(21) Application number: 13153902.5
(22) Date of filing: 04.02.2013
(51) Int. Cl.: G06F 1/20, H01L 23/467, H05K 7/20, F04D 29/60

(54) **Buckle and heat dissipation module having the same**

(71) Applicant: SilverStone Technology Co., Ltd., Zhonghe Dist., New Taipei City 235 (TW)
(72) Inventor: Hsu, Yung-lin, 235 New Taipei City (TW); Liu, Kuan-yu, 235 Chinese Taipei (TW)
(74) Representative: Ter Meer Steinmeister & Partner

(57) **Abstract**

A heat dissipation module includes a fin stack (100), a fan (200) and buckles (300). The fin stack (100) includes fins (110) arranged at interval and in parallel with each other, wherein a notch (111) is formed at an edge of each fin (110) and the notches (111) of the fins (110) are in alignment. The fan (200) includes through holes (211). Each buckle (300) includes an elastic connecting piece (310), a first cylinder (320) and a second cylinder (330). An extension portion (311) is formed at one end of the elastic connecting piece (310). A lateral side of the first cylinder (320) connects the extension portion (311). The second cylinder (330) vertically extends from the other end of the elastic connecting piece (310). The first cylinder (320) is snapped on corresponding notches (111). The second cylinder (330) is received in a corresponding through hole (211). Whereby, the first cylinder (320) could be easily snapped on and removed from the notch (111).

## Description

### BACKGROUND OF THE INVENTION

### Field of the Invention

The present invention relates to a heat dissipation module, and in particular to a heat dissipation module which is easy for installation and the buckle thereof.

### Description of Prior Art

Heat dissipation modules are commonly used in electronic thermal field. Generally, a conventional heat dissipation module includes a fin stack and a fan. The fin stack includes fins connected to a heat-conductive plate by a heat pipe. The heat-conductive plate contacts a heat source. For example, the heat source could be a CPU (central processing unit) or a GPU (graphics processing unit). Heat generated by the heat source spreads in the heat-conductive plate. The heat is transferred to the fins through the heat pipe, and further dissipated into atmosphere via forced air convention.

Therefore, the fin stack has to be locked with the fan. Buckles are commonly used for connection between the fin stack and the fan. Because the fan is firmly connected with the fin stack, it is usually difficult to remove buckles from the fin stack.

For example, the buckles mentioned in patents TW M300837 and TW M342542 are difficult to be removed from the fin stack. Hence, the parts of a conventional heat dissipation module may be damaged by operators in production lines or consumers when assemble the heat dissipation module.

### SUMMARY OF THE INVENTION

This invention provides a heat dissipation module and a buckle thereof, wherein the fan and the fin stack of the heat dissipation module could be easily assembled or disassembled.

The heat dissipation module includes a fin stack, a fan and a plurality of buckles. The fin stack includes a plurality of fins arranged at interval and in parallel with each other, wherein a notch is formed at an edge of each fin and notches of the fins are in alignment. The fan includes a plurality of through holes. Each buckle includes an elastic connecting piece, a first cylinder and a second cylinder. An extension portion is formed at one end of the elastic connecting piece. A lateral side of the first cylinder connects the extension portion. The second cylinder vertically extends from the other end of the elastic connecting piece. The first cylinder is snapped on corresponding notches. The second cylinder is received in a corresponding through hole. Whereby, the first cylinder could be easily assembled with the corresponding notches and easily disassembled.

Furthermore, the first cylinder is formed with a plurality of flanges arranged at interval and in parallel with each other, and one fin is engaged between two adjacent flanges. An axis of the first cylinder and an axis of the second cylinder are perpendicular with each other. The extension portion is bent with respect to the elastic connecting piece. The second cylinder has a tapered portion to plug on the corresponding through hole. The tapered portion is in a cone shape, a taper direction of the tapered portion is the same as an extending direction of the second cylinder. The fan includes a frame. The through holes are formed on the frame.

The fan is locked with the fin stack by the first cylinder. Moreover, the first cylinder could be easily removed from corresponding notches via pulling the extension portion. Whereby, the heat dissipation module and the buckle of the present invention amend the disadvantage of prior technologies.

### BRIEF DESCRIPTION OF DRAWING

FIG. 1 is a schematic view showing the preferred embodiment of the present invention;
FIG. 2 is an explosion diagram showing the preferred embodiment of the present invention;
FIG. 3 is a schematic view showing the fan and the buckles in the preferred embodiment of the present invention;
FIG. 4 is a schematic view showing the buckle in the preferred embodiment of the present invention;
FIG. 5 is a schematic view showing the buckles in the preferred embodiment of the present invention in another viewpoint;
FIG. 6 is the section view of the heat dissipation module shown in FIG 1;
FIG. 7 is a schematic view showing the buckle which is bent in the preferred embodiment of the present invention;
FIG. 8 is the partially enlarged view of the heat dissipation module shown in FIG 6.

### DETAILED DESCRIPTION OF THE INVENTION

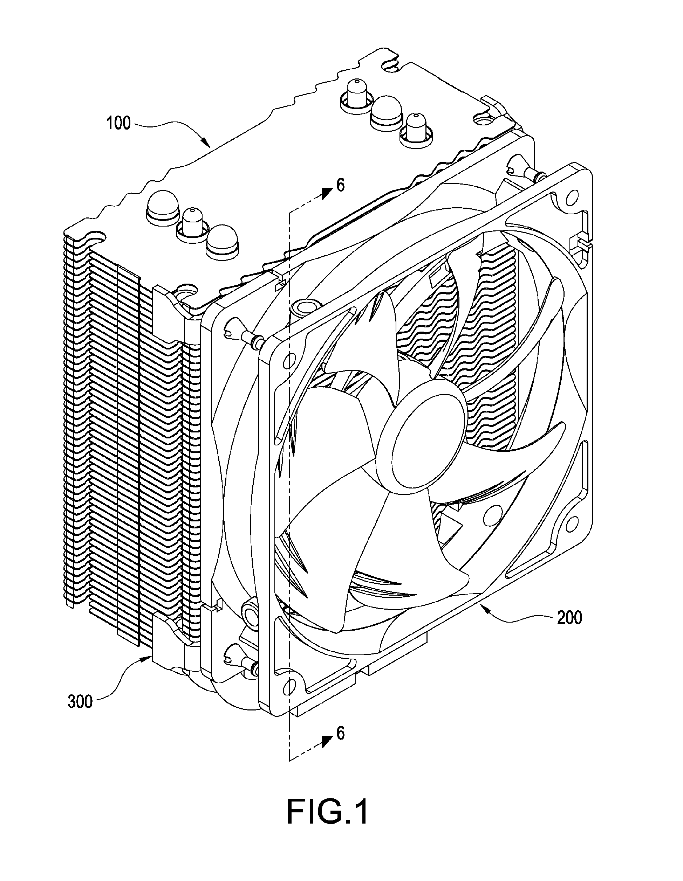

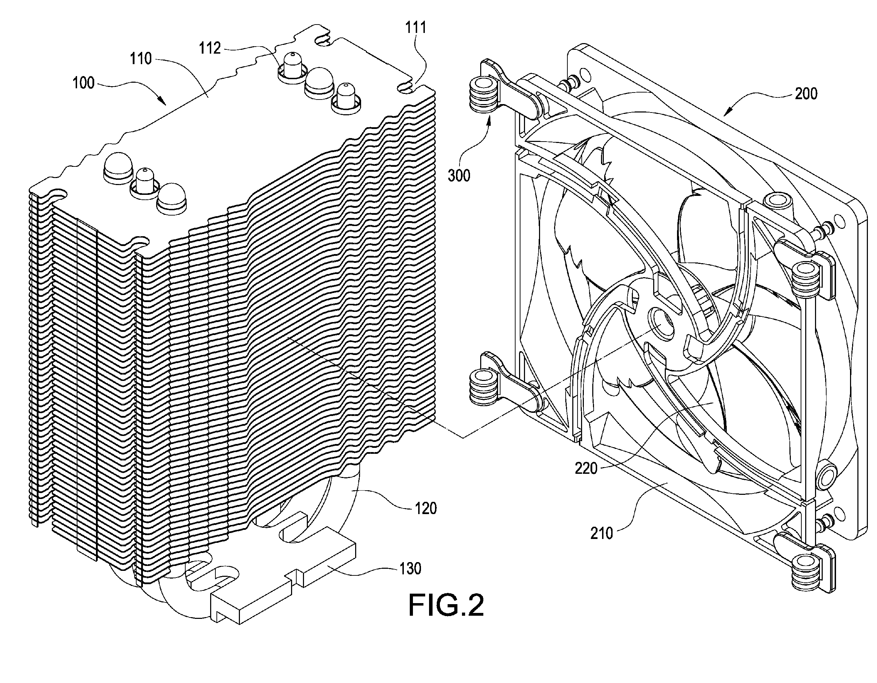

Please refer to FIG. 1 and FIG 2. The first embodiment of the present invention provides a heat dissipation module including a fin stack 100, a fan 200 and a plurality of buckles 300. The buckles are used for firmly locking the fan 200 on the fin stack 100.

Please refer to FIG 2. The fin stack 100 preferably includes fins 110, heat pipes 120 and a heat-conductive plate 130. The fins 110 are made of metal with superior heat transfer efficiency. For example, the fins 110 could be made of aluminum or copper. The fins 110 are arranged at interval and in parallel with each other. In each fin 110, a notch 111 is punched at the edge of each fin 110, and the notches 111 of the fins 110 are arranged in alignment. In this embodiment, each fin 110 is preferably punched six heat-conductive holes 112. The number of the heat pipes 120 corresponds with the number of the heat-conductive holes 112. The fin stack 100 preferably includes three U-shaped heat pipes 120, wherein each end of the heat pipe 120 is received in a corresponded heat conductive hole 112, whereby the heat pipes 120 connect the fins 110. The heat-conductive plate 130 connects the central segment of each heat pipe 120.

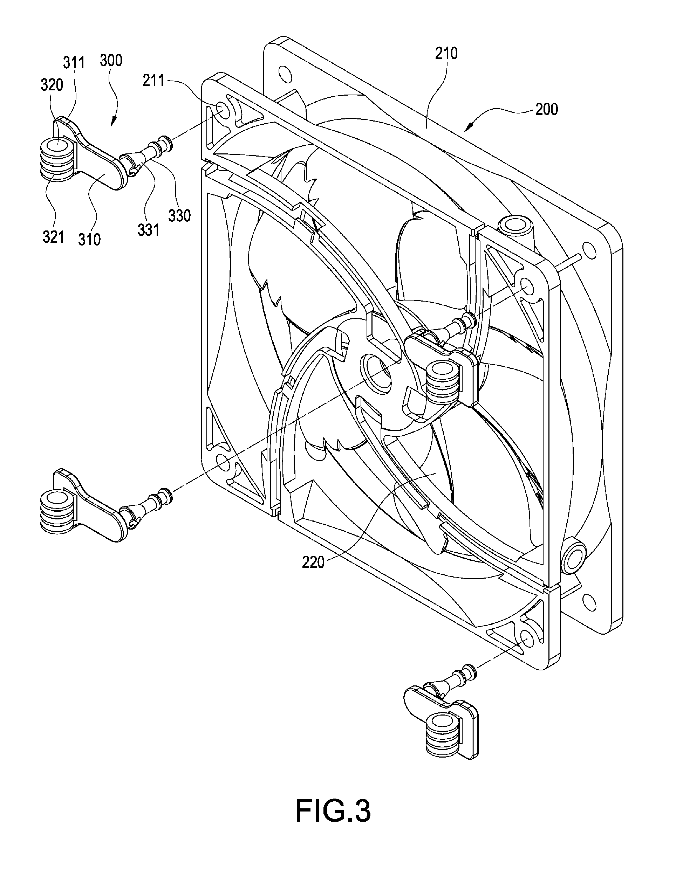

Please refer to FIG 3. The fan 200 includes a frame 210 and a fan wheel 220 which is set in the frame 210. The frame 210 is of a rectangular-piece shape. Through holes 211 are provided on the frame 210. In the present embodiment, four through holes 211 are provided at the four corners of the frame 210.

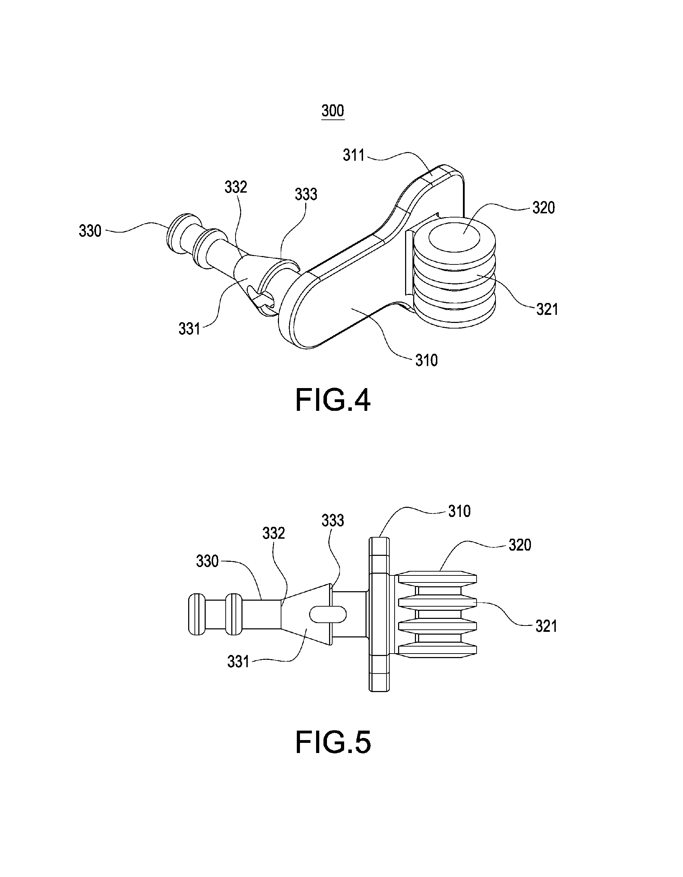

Please refer to FIG 3 to FIG 5. In the present embodiment, the heat dissipation module of the present invention includes four buckles 300 corresponding to each through hole 211. Each buckle 300 is integrally molded by elastic material which is preferably silicon or rubber. The buckle 300 includes an elastic connecting piece 310, a first cylinder 320 and a second cylinder 330. The elastic connecting piece 310 is of a bar shape. An extension portion 311 is formed at one end of the elastic connecting piece 310. A lateral side of the first cylinder 320 is connected to the extension portion 311. A plurality of flanges 321 are parallel arranged on the lateral face of the first cylinder 320. Each flange 321 surrounds the lateral side of the first cylinder 320. In the present embodiment, four flanges 321 are provided on each first cylinder 320, but the number of the flange 321 on each first cylinder 320 is not a limitation of the present invention. The second cylinder 330 is perpendicularly extends from the other end of the elastic connecting piece 310. In the present embodiment, the first cylinder 320 and the second cylinder 330 are provided on opposite lateral faces of the elastic connecting piece 310. Furthermore, the first cylinder 320 and the second cylinder 330 are perpendicular with each other. The second cylinder 330 has a conic tapered portion 331 to plug on the corresponding through hole 211. A taper direction of the tapered portion 331 is the same as an extending direction of the second cylinder 330.In the present embodiment, the tapered portion 331 has a tip 332 and a blunt end 333, and the outer diameter of the blunt end 333 is larger than the inner diameter of the through hole 211.

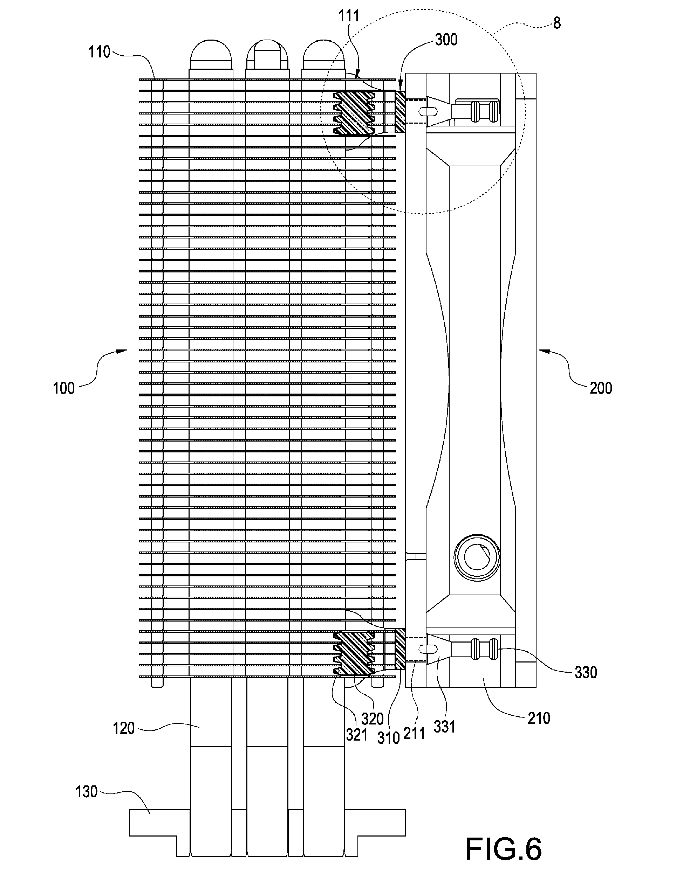

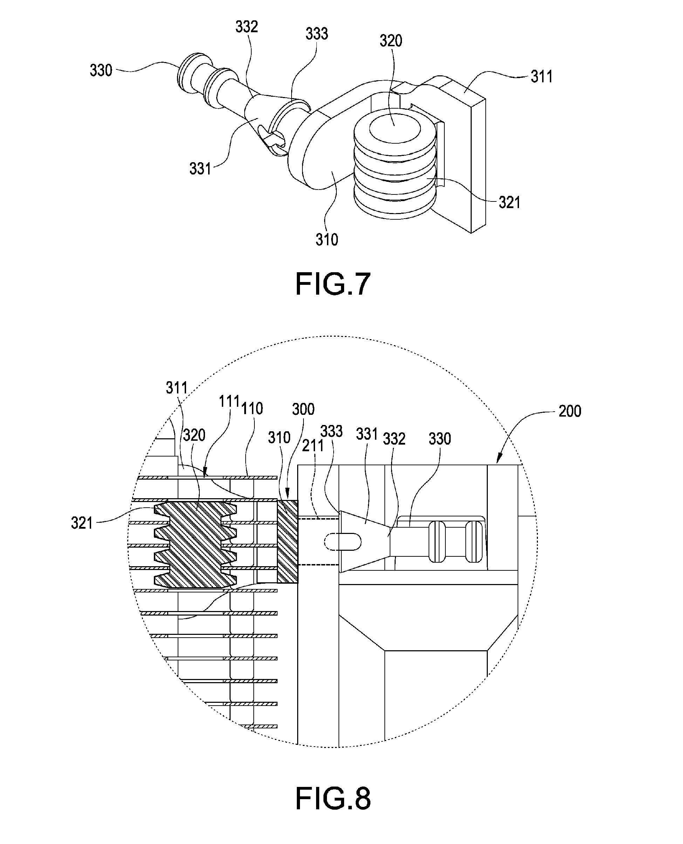

Please refer to FIG 6 to FIG 8. The second cylinder 330 is received in the through hole 211 of the fan 200. The tip 332 of the tapered portion 331 is inserted into the corresponding through hole 211 in advance, and then the blunt end 333 of the tapered portion 331 is elastically pressed by the inner wall of the through hole 211 to facilitate the entrance of the blunt end 333. After passing through the through hole 211, the blunt end 333 of the tapered portion 331 restores resiliently and sticks in the through hole 211. Therefore, the buckle 300 is fixed on the fan 200. The elastic connecting piece 310 is bent with respect to the elastic connecting piece to make the first cylinder 320 be snapped on corresponding notches 111 at the edges of the fins 110. In the present embodiment the first cylinder 310 is snapped on three aligned notches 111. Each fin is engaged between two adjacent flanges 321, and the three fins 110 are engaged with four flanges 321.

In the present invention, the fin stack 100 and the fan 200 are connected by buckles 300 which are made of elastic materials. Therefore, the buckles 300 would not damage the fins 110 while the fin group 100 and the fan 200 are assembled or disassembled. Moreover, the fan 200 could be easily set on the fin stack 100 by means of snapping the first cylinder 320 into the notch 111 of the fin 110. While the first cylinder 320 is pulled, the fins 110 could be protected by the flanges 321 to prevent from being damaged by the first cylinder 320. Furthermore, each first cylinder 320 could be pulled out from the notches 111 by pulling the extension portion 311. Accordingly, the fan 200 could be easily removed from the fin stack 100. Therefore, in the present invention, the fin stack 100 and the fan 200 could be firmly connected by the buckles 300 and could be easily disassembled.

## Claims

1. A heat dissipation module, comprising:
a fin stack (100) comprising a plurality of fins (110) arranged at interval and in parallel with each other, wherein a notch (111) is formed at an edge of each fin (110) and notches (111) of the fins (110) are in alignment;
a fan (200) comprising a plurality of through holes (211); and
a plurality of buckles (300);
wherein each buckle (300) comprises an elastic connecting piece (310), a first cylinder (320) and a second cylinder (330), an extension portion (311) is formed at one end of the elastic connecting piece (310), a lateral side of the first cylinder (320) connects the extension portion (311), the second cylinder (330) vertically extends from the other end of the elastic connecting piece (310), the first cylinder (320) is snapped on corresponding notches (111), and the second cylinder (330) is received in a corresponding through hole (211).

2. The heat dissipation module according to claim 1, wherein the first cylinder (320) is formed with a plurality of flanges (321) arranged at interval and in parallel with each other, and one fin (110) is engaged between two adjacent flanges (321).

3. The heat dissipation module according to claim 1, wherein an axis of the first cylinder (320) and an axis of the second cylinder (330) are perpendicular with each other.

4. The heat dissipation module according to one of claim 1, 2 and 3, wherein the extension portion (311) is bent with respect to the elastic connecting piece (310).

5. The heat dissipation module according to claim 1, wherein the second cylinder (330) has a tapered portion (331) to plug on the corresponding through hole (211).

6. The heat dissipation module according to claim 5, wherein the tapered portion (331) is in a cone shape, a taper direction of the tapered portion (331) is the same as an extending direction of the second cylinder (330).

7. The heat dissipation module according to claim 1, wherein the fan (200) comprises a frame (210), and the through holes (211) are formed on the frame (210).

8. A buckle (300) comprising:
an elastic connecting pieces (310) having an extension portion (311) formed at one end;
a first cylinder (320) having a lateral side connecting the extension portion (311); and
a second cylinder (330) vertically extending from the other end of the elastic connecting piece (310).

9. The buckle (300) according to claim 10, wherein the second cylinder (330) has a tapered portion (331) and a taper direction of the tapered portion is the same as an extending direction of the second cylinder (330).
